Europäisches Patentamt

(19) European Patent Office

Office européen des brevets

(11) Numéro de publication: **0 015 168**
B1

(12) **FASCICULE DE BREVET EUROPEEN**

(45) Date de publication du fascicule du brevet: **09.02.83**

(51) Int. Cl.³: **G 01 R 33/02, H 03 H 2/00**

(21) Numéro de dépôt: **80400064.4**

(22) Date de dépôt: **15.01.80**

(54) Magnétomètre à ondes magnétostatiques.

(30) Priorité: **27.02.79 FR 7905006**

(43) Date de publication de la demande:
**03.09.80 Bulletin 80/18**

(45) Mention de la délivrance du brevet:
**09.02.83 Bulletin 83/6**

(84) Etats contractants désignés:
**DE GB NL SE**

(56) Documents cités:
**DE - A - 2 245 191**
**US - A - 3 490 034**

**PROCEEDINGS OF THE IEEE, vol. 64, no. 5, (mai 1976) pages 794—800. London, GB J. D. ADAM et al. "Microwave magnetostatic delay devices based on epitaxial YiG"**
**ELECTRONIC LETTERS, vol. 11, no. 25/26 (11—12—1975), pages 610, 611. Hertz GB A. K. GANGULY et al. "Magnetically tuned surface-acoustic-wave phase shifter".**

(73) Titulaire: **THOMSON-CSF**
**173, Boulevard Haussmann**
**F-75379 Paris Cedex 08 (FR)**

(72) Inventeur: **Castera, Jean-Paul**
**"THOMSON-CSF" - SCPI 173, Bld Haussmann**
**F-75360 Paris Cedex 08 (FR)**
Inventeur: **Hartemann, Pierre**
**"THOMSON-CSF" - SCPI 713, bld Haussmann**
**F-75360 Paris Cedex 08 (FR)**

(74) Mandataire: **Wang, Pierre et al,**
**THOMSON-CSF SCPI 173, Bld Haussmann**
**F-75379 Paris Cedex 08 (FR)**

Courier Press, Leamington Spa, England.

## Magnétomètre à ondes magnétostatiques

La présente invention concerne un magnétomètre à ondes magnétostatiques du type unidirectionnel, c'est à dire sensible essentiellement à une composante d'un champ magnétique extérieur, selon le préambule de la revendication 1.

Parmi les magnétomètres de type connu, certains sont sensibles à l'intensité du champ magnétique, par exemple les magnétomètres à pompage optique; d'autres sont unidirectionnels, c'est à dire délivrent un signal proportionnel à la composante du champ selon une direction prédéterminée. Ce dernier type de magnétomètre met en oeuvre généralement le déplacement d'un conducteur dans un champ magnétique, ce qui induit une tension électrique. Le conducteur est généralement fragile. Les déplacements entraînent de l'usure et des réglages préalables sont nécessaires.

Les applications potentielles des dispositifs à ondes magnétostatiques tels que lignes à retard réglable et oscillateurs sont abordées dans un article de la revue Proceedings of the IEEE, Vol. 64, N° 5, (mai 1976) pages 794—800, London, GB, intitulé "Microwave magnetostatic delay devices based on epitaxial VIG" par J. D. ADAM et al. Le document US—A—3 490 034 fait référence à un dispositif de mesure de champ magnétique utilisant deux oscillateurs à inductances dont l'une au moins est sensible au champ magnétique à mesurer et qui prend pour caractéristique de mesure la différence des fréquences d'oscillation.

La revue Electronics Letters, vol. 11, n° 25/26 (11—12—1975) Hertz, GB, mentionne aux pages 610, 611 un article intitulé "Magnetically tuned surface acoustic wave phase shifter" par A. K. GANGULY et al dans lequel est décrit un dispositif expérimental où la vitesse d'ondes de Rayleigh est influencée par l'action d'un champ magnétique sur un film mince magnétostrictif. Les indications données ci-dessus représentent l'arrièreplan technologique de l'invention, laquelle vise à remédier aux inconvénients des dispositifs connus par un dispositif monolithique, aisé à réaliser et fournissant un signal dont la fréquence varie avec la composante du champ, ce qui conduit à une numérisation facile.

Dans un magnétomètre selon le préambule de la revendication 1, ce but est atteint par les moyens figurant dans la partie caractérisante de cette revendication.

L'invention utilise les ondes magnétostatiques pouvant se propager dans une couche mince d'un matériau magnétique placée dans un champ magnétique extérieur. Ces ondes peuvent être excitées au moyen d'un transducteur dans lequel circule un courant hyperfréquence. Il est connu de les utiliser pour réaliser un oscillateur comprenant soit une ligne à retard comprise entre deux transducteurs et bouclée au moyen d'un amplificateur, soit une cavité résonnante à réseaux. Les fréquences d'oscillation que l'on obtient sont situées dans la gamme hyperfréquence et dépendent de la valeur du champ magnétique extérieur. Lorsqu'on a déterminé la loi de dépendance, il est possible d'utiliser de tels oscillateurs pour mesurer des variations de champ magnétique se superposant à un champ magnétique constant. Lorsque ces variations sont assez faibles, la loi de dépendance est linéaire et la mesure de la variation de fréquence du signal de sortie est alors proportionnelle à la variation de la composante de champ magnétique à laquelle est sensible l'oscillateur. Le magnétomètre selon l'invention comprend deux oscillateurs soumis à des champs magnétiques constants d'intensités voisines, de même direction mais de sens opposés, auquel se superpose le champ magnétique à mesurer identique pour les deux oscillateurs. Les signaux de sortie des deux oscillateurs sont mélangés de façon à obtenir un signal dont la fréquence est égale à la différence des deux fréquences d'oscillation. Cette configuration permet de diminuer la fréquence de travail depuis la gamme hyperfréquence jusqu'à une gamme très inférieure. D'autre part, les oscillateurs étant réalisés à partir d'une même couche de matériau magnétique, le dispositif peut être rendu symétrique et les effets de température sont compensés. Enfin la variation de fréquence du signal de sortie est ainsi doublée par rapport à la variation de chacune des deux fréquences d'oscillation.

L'invention sera mieux comprise et d'autres caractéristiques apparaitront à l'aide de la description ci-après et des figures annexées parmi lesquelles:

—la figure 1 représente un magnétometre à ondes magnétostatiques de surface formé de deux résonateurs.

—la figure 2 illustre la fabrication du dispositif de la figure 1.

—la figure 3 représente un mode de réalisation d'un magnétomètre permettant une amélioration de le compensation des dérives en température.

—la figure 4 est une vue en plan d'un magnétomètre à ondes magnétostatiques de surface comprenant deux lignes à retard.

—la figure 5 est une vue en coupe d'un magnétomètre à ondes magnétostatiques de volume comprenant deux résonateurs.

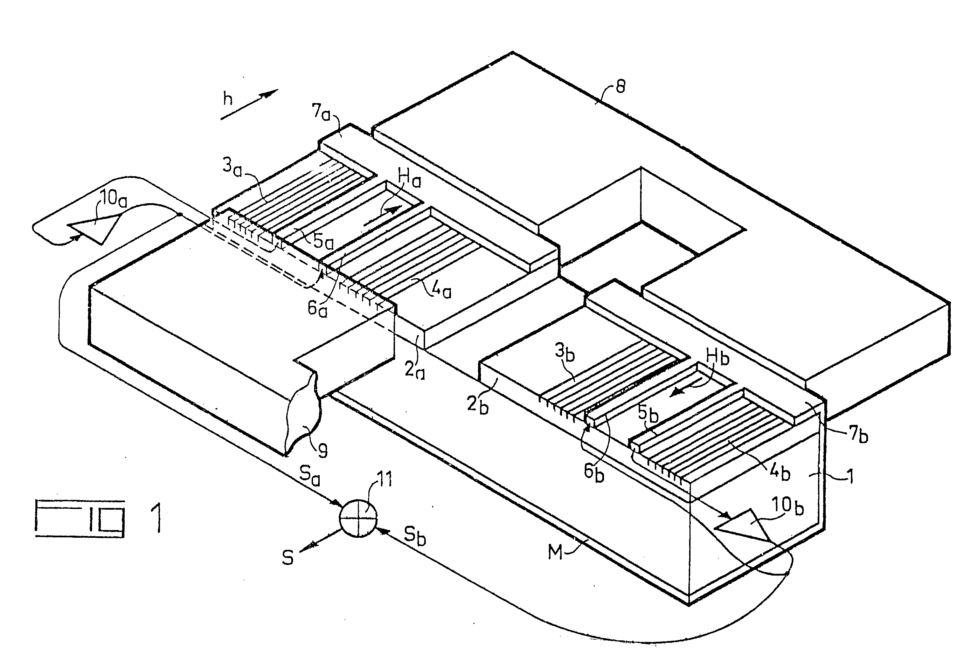

Le dispositif représenté sur la figure 1 est un magnétomètre à deux cavités résonnantes utilisant les ondes magnétostatiques de surface. Ce dispositif comprend les éléments suivants:

—un substrat 1 réalisé dans un grenat non magnétique, par exemple un grenat de gadolinium-gallium (GGG).

—une couche magnétique déposée sur le substrat et composée de deux parties 2a et 2b, faite par exemple d'un grenat d'yttrium-fer (YIG) déposé par épitaxie en phase liquide.

—deux aimants en U 8 et 9 enserrant chacune des deux couches magnétiques 2a et 2b de façon à y créer des champs constants de même direction et de sens opposés, respectivement Ha, Hb. Four créer ces champs un seul aimant pourrait d'ailleurs suffir, par exemple l'aimant 8. La direction des champs Ha et Hb est choisie de façon à permettre la propagation d'ondes de surface dans la couche magnétique. Cette direction est donc comprise dans le plan de la couche et est perpendiculaire à la direction de propagation.

—dans chacune des deux couches 2a et 2b est créée une cavité résonnante au moyen de réseaux de sillons gravés dans la couche respectivement 3a, 4a et 3b et de transducteurs d'entrée et de sortie respectivement 5a, 6a et 5b, 6b. Chaque transducteur est fait d'une bande métallique étroite déposée sur la couche magnétique dont une extrémité est reliée à un plan de masse M situé dans la partie inférieure du substrat 1, cette couche se prolongeant sur un côté du substrat et venant reconvrir une partie des couches 2a et 2b sous la forme de dépôts 7a et 7b. Les sillons des réseaux et les bandes métalliques constituant les transducteurs sont parallèles aux champs Ha et Hb de façon à permettre la propagation des ondes de surface dans la direction perpendiculaire. On sait que les ondes magnétostatiques de surface sont unidirectionnelles, c'est à dire qu'elles se propagent exclusivement à l'interface YIG-air dans l'un des sens de propagation et à l'interface YIG-GGG dans l'autre sens, ces sens dépendant du sens du champ magnétique appliqué. Les sens de propagation sont donc inversés pour les deux cavités puisque les champs magnétiques Ha et Hb sont de sens opposés. Les transducteurs 5a, 5b et 6b sont placés de façon que les transducteurs 6a et 6b soient des transducteurs d'entrée, c'est à dire reçoivent un courant hyperfréquence et couplent les ondes magnétostatiques en direction respectivement du réseau 4a et du réseau 3b, alors que les transducteurs 5a et 5b sont des transducteurs de sortie, c'est à dire reçoivent les ondes issues respectivement des réseaux 3a et 4b et convertissent l'énergie en un courant hyperfréquence.

—les signaux hyperfréquences reçus par les transducteurs d'entrée 6a et 6b proviennent respectivement de circuits amplificateurs à résistance négative 10a et 10b dont les entrées sont reliées respectivement aux transducteurs de sortie 5a et 5b. Les signaux issus des amplificateurs: Sa et Sb sont mélangés au moyen d'un mélangeur 11 qui fournit un signal S dont la fréquence est égale à la différence des fréquences des signaux Sa et Sb.

Le fonctionnement du dispositif est le suivant: en l'absence de champs magnétiques venant s'ajouter aux champs créés par les aimants, le signal Sa a une fréquence Fa et le signal Sb a une fréquence Fb. Le signal de sortie S a une fréquence Fa—Fb que l'on peut ajuster à la valeur voulue, par exemple en déplaçant les aimants. Lorsque le dispositif est soumis à un champ magnétique h parallèle aux champs créés par les aimants, ce champ h s'ajoute en intensité à l'un des champs Ha et Hb et se retranche en intensité à l'autre, par exemple la couche 2a est soumise à un champ Ha+h et la couche 2b est soumise à un champ Hb—h. On sait que les fréquences d'oscillation d'un oscillateur à ondes magnétostatiques varient avec le champ magnétique, dans le même sens. Le signal Sa a donc pour fréquence Fa+ΔFa et le signal Sb a pour fréquence Fb—ΔFb. Si les fréquences Fa et Fb sont voisines et si les variations ΔFa et ΔFb sont faibles par rapport aux fréquences Fa et Fb, les relations de dépendance fréquence-champ magnétique peuvent être considérées comme linéaire, et les variations ΔFa et ΔFb sont approximativement égales. Le signal de sortie S a pour fréquence Fa—Fb+2 ΔF. Si le champ h a une direction différente de celle qui induit les ondes de surface, des ondes de volume sont induites simultanément aux ondes de surface en raison des deux composantes: perpendiculaire au plan de la couche et dans le plan de la couche parallèle à la direction de propagation. Toutefois, ces ondes de volume sont situées dans des gammes de fréquences très différentes ce celles des ondes magnétostatiques de surface, elles n'ont donc pas d'influence sur le signal de sortie. Il est possible d'ajuster la différence $F_a$—$F_b$ à une valeur commode pour la mesure soit en modifiant les champs $H_a$ et $H_b$ en déplaçant légèrement les aimants, soit en agissant sur le temps de propagation dans les cables de liaison des amplificateurs, c'est à dire en modifiant leur longueur. Le champ à mesurer h peut être continu, ou bien alternatif, par exemple de fréquence f. Dans le cas, le signal S est modulé en fréquence.

La description du fonctionnement donnée ci-dessus ne tient pas compte du fait que les oscillateurs ont en général plusieurs fréquences d'oscillation. En effet, dans la bande passante en résonance d'une cavité, il existe plusieurs modes distants en fréquence d'une valeur égale à

$$\frac{V}{2L}$$

où L est la longueur équivalente de la cavité et v la vitesse des ondes magnétostatiques dans la couche magnétique. Four obtenir un oscillateur monomode on peut augmenter l'écart entre les modes en diminuant la longueur équivalente da la cavité, ce qui a pour effet de diminuer également son coefficient de qualité, ou bien diminuer la largeur de bande en augmentant le nombre de sillons par réseau, mais ceci implique une augmentation de la longueur équivalente, donc une diminution de l'écart entre modes. Un compromis peut être trouvé entre les deux de façon à obtenir une largeur de bande juste égale à l'écart entre modes. L'invention est réalisable avec une couche de YIG d'épaisseur 10 $\mu$m dans laquelle l'aimantation à saturation mesurée vaut 4 $\pi$M=1750 Oe. Dans cette couche, on a gravé par bombardement ionique des sillons de profondeur 2,8 $\mu$m. Les champs $H_a$ et $H_b$ étant égaux à environ 200 Oe, les fréquences d'oscillations $F_a$ et $F_b$ valent environ 2,25 GHz et la sensibilité de ce dispositif est de l'ordre de 4 MHz/Oe. On peut mesurer une difference de fréquence de quelques dizaines de Hz, ce qui correspond à une résolution de l'ordre de $10^{-5}$ Oe.

Pour que les dérives en température dues aux variations de l'aimantation en fonction de la température soient compensées entre les deux oscillateurs, il faut que le dispositif de la figure 1 soit symétrique de façon que les deux oscillateurs présentent des dérives aussi égales que possible.

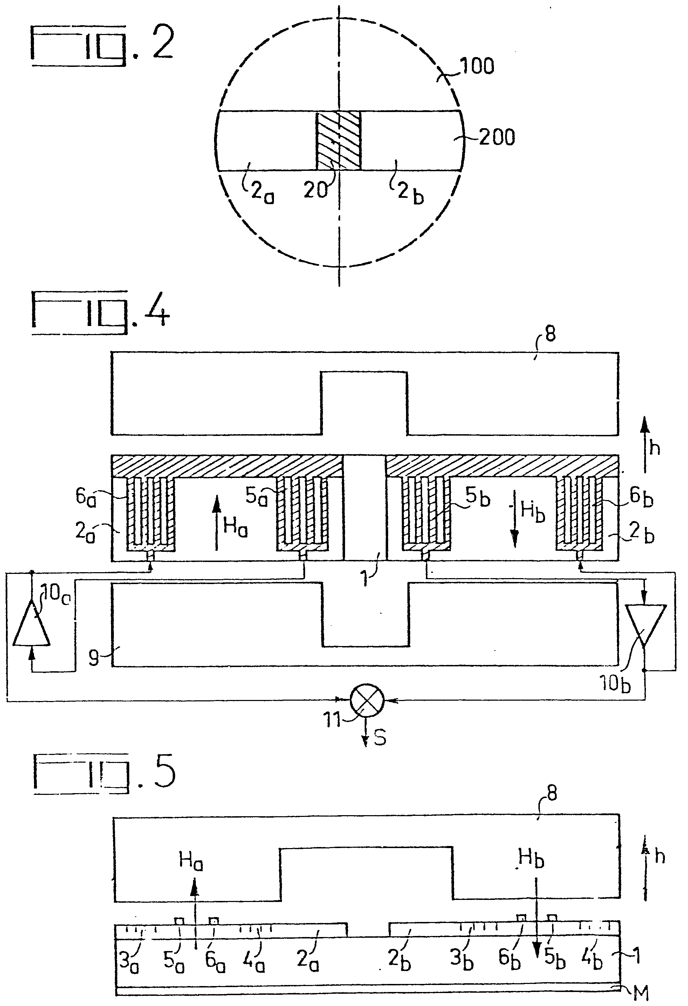

La figure 2 illustre le mode de réalisation préconisé des deux oscillateurs. On part d'un disque de GGG sur lequel est déposée par épitaxie en phase liquide une couche d'épaisseur prédéterminée de YIG 100. L'épitaxie est effectuée de façon circulaire, si bien que le disque possède un centre de symétrie. On découpe au centre du disque un parallélépipède 200 qui possède un axe de symétrie passant par le centre; au milieu du parallélépipède, le YIG est enlevé par sablage sur une zone 20 de façon à isoler les deux parties de couche de YIG 2a et 2b sur lesquelles sont réalisées les deux cavités par gravure des réseaux et dépôt des transducteurs d'entrés et de sortie. La précision sur la gravure et sur le dépôt peut être très bonne grâce aux techniques couramment utilisées de microlithographie si bien que l'on peut obtenir une symétrie entre les deux cavités qui peuvent avoir des réponses en température très voisines. En supposant que la température est la même pour les deux parties du dispositif, lorsque cette température varie, l'aimantation du YIG varie également: elle diminue lorsque la température augmente. Lorsque l'aimantation diminue, les fréquences d'oscillation des deux cavités diminuent également. Si les variations de fréquence sont égales pour les deux parties, lorsqu'on mélange les signaux Sa et Sb les effets s'annulent. Selon les applications de ce magnétomètre, la compensation en température obtenue de façon indiquée précédemment peut être suffisante. Toutefois dans certains cas les variations de température cu la précision demandée sur la mesure du champ magnétique sont trop importantes pour que cette compensation suffise. Plusieurs remèdes peuvent être envisagés: pour obtenir une température rigoureusement uniforme sur tout le dispositif il peut être intéressant de placer l'ensemble du parallélépipède 200 dans un liquide par exemple de l'huile ayant une bonne inertie thermique.

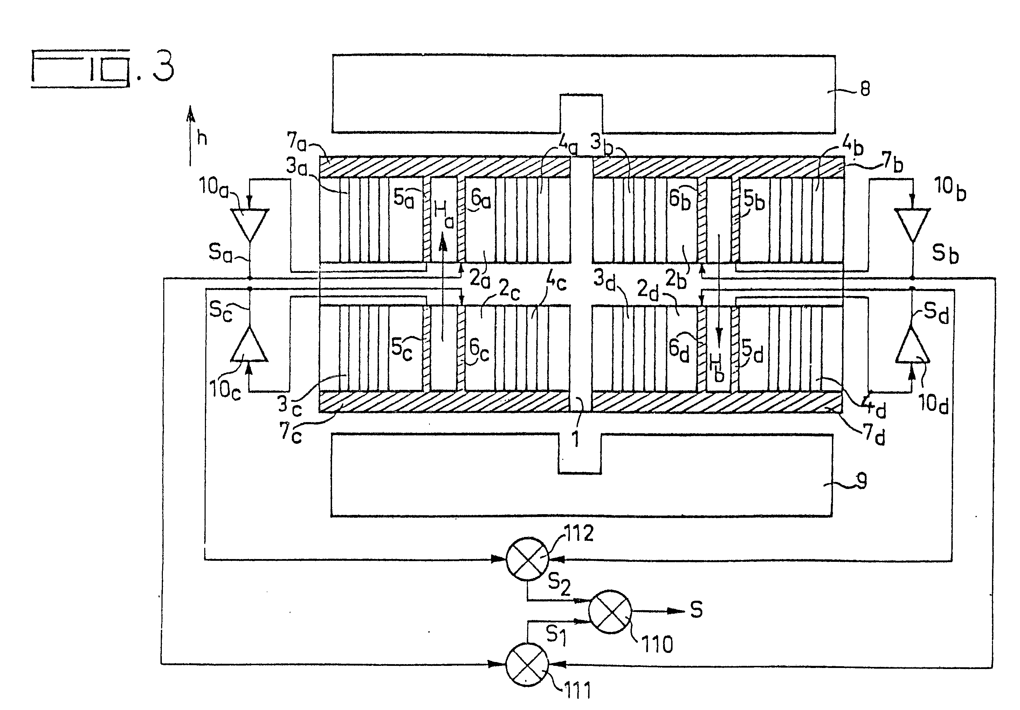

Une autre manière d'améliorer la compensation des dérives en température est représentée sur la figure 3. Cette figure est une vue en plan d'un magnétomètre comprenant quatre oscillateurs à cavité résonnante sur un même substrat de GGG 1 sur lequel est déposée une couche de YIG partagée en quatre parties 2a, 2b, 2c et 2d séparées entre elles par des zones obtenues par sablage comme précédemment. Il s'agit donc d'un dispositif double de celui de la figure 1. Des cavités sont réalisées sur les parties 2a, 2b, 2c, 2d respectivement au moyen de paires de réseaux: 3a—4a, 3b—4b, 3c—4c, 3d—4d, et sont bouclées par des circuits amplificateurs 10a, 10b, 10c, 10d fournissant des signaux Sa, Sb, Sc, Sd respectivement entre des transducteurs d'entrée-sortie: 5a—6a, 5b—6b, 5c—6c, 5d—6d. L'ensemble est placé dans les champs magnétiques de deux aimants 8 et 9 disposés comme sur la figure 1 et fournissant des champs en sens opposés: Ha pour les parties 2a et 2c et Hb pour les parties 2b et 2d. Les signaux Sa et Sb sont mélangés dans un mélangeur 111 fournissant un signal Si et les signaux Sc et Sd sont mélangés dans un mélangeur 112 fournissant un signal S2. Les signaux Si et S2 sont appliqués à un mélangeur 112 fournissant le signal de sortie S permettant la mesure du champ magnétique extérieur h. Supposons que le champ à mesurer h soit dans le même sens que le champ Ha. Les fréquences des signaux Sa et Sc varient dans le même sens que l'intensité du champ h, par contre des fréquences des signaux Sb, Sd varient en sens contraire. Si pour un champ donné les variations sont toutes égales en valeur absolue, la variation totale de fréquence du signal S est égale à quatre fois la variation de fréquence d'un seul oscillateur. Au contraire, les variations de fréquence dûes à une variation de température ont le même signe pour les quatres oscillateurs. La variation relative de fréquence par rapport à la variation en température du signal S est égale au produit des variations relatives des signaux S1 et S2. On gagne donc un facteur important par rapport à un dispositif comprenant une seule paire d'oscillateurs. On peut choisir des fréquences d'oscillations en l'absence de champs magnétiques extérieurs de la façon suivante: Fa=Fc, Fd Fa Fb. La fréquence du signal F est égale à F=Fa—Fb+Fc—Fd. Lorsqu'une variation $\Delta$F est dûe à un champ magnétique, la fréquence devient Fa—Fb+Fc—Fd+4$\Delta$F. Les valeurs exactes de ces fréquences peuvent être ajustées en agissant sur les retards introduits par les boucles des amplificateurs.

D'autres modes de réalisation de magnétomètres comprenant au moins deux oscillateurs sont représentés sur les figures 4 et 5. La figure 4 représente un magnétomètre comprenant deux oscillateurs à ligne à retard utilisant les ondes de surface. Les lignes à retard sont réalisées sur deux parties 2a et 2b d'une couche de YIG déposée sur un substrat 1 de GGG comme précédemment. Les champs magnétiques Ha et Hb sont obtenus de la même façon que précédemment, et les lignes à retard sont bouclées par des amplificateurs 10a et 10b. Pour obtenir un fonctionnement monomode, on réalise les entrées-sorties des signaux dans les lignes par des transducteurs multiples disposés en parallèle 5a, 6a et 5b, 6b. Ce type de magnétomètre a toutefois des caractéristiques moins bonnes qu'un magnétomètre à résonateurs, du fait que le coefficient de qualité d'un oscillateur à ligne à retard est, à fréquence d'oscillation égale, moins élevé que celui d'un oscillateur à résonateur.

La figure 5 représente un magnétomètre utilisant les ondes de volume. Une façon d'obtenir les ondes de volume est de soumettre la couche de YIG à un champ perpendiculaire à sa surface. On place donc un aimant 8 au-dessus des deux parties 2a et 2b de la couche YIG. Le magnétomètre représenté est un magnétomètre à résonateure. Son fonctionnement est semblable à celui du magnétomètre à ondes de surface. Les sensibilités obtenues ainsi que les valeurs nominales de fréquence sont différentes. On pourrait aussi réaliser un oscillateur à ondes de volume avec un champ magnétique parallèle à la direction de propagation des ondes. L'avantage du magnétomètre de la figure 5 est qu'il est beaucoup plus compact que ceux que l'on peut réaliser avec des champs parallèles à la couche. Ce faible encombrement peut être intéressant dans un certain nombre d'applications.

**Revendications**

1. Magnétomètre à ondes magnétostatiques comprenant au moins deux oscillateurs hyper-fréquence sensibles aux ondes magnéto-statiques, caractérisé en ce que ces derniers comprennent un dispositif monolithique avec chacun une couche de matériau magnétique (2a, 2b), soumise au champ à mesurer (h), des moyens électromagnétiques (8, 9) pour soumettre leadites couches respectivement à des champs magnétiques prédéterminés de même direction ($H_a$, $H_b$), cette direction étant la direction de sensibilité maximale, de sens opposés et d'intensités voisines, lesdits oscillateurs présentant des fréquences d'oscillation voisines; ledit magnétomètre comprenant en outre des moyens mélangeurs (11) ayant deux entrées respectivement reliées aux oscillateurs ($10_a$, $10_b$) pour fournir un signal dont la fréquence est égale à la différence des fréquences d'oscillation des deux oscillateurs et est variable en fonction de la composante du champ à mesurer suivant ladite direction.

2. Magnétomètre selon la revendication 3, caractérisé en outre par un substrat non magnétique (1) sur lequel sont déposées lesdites couches magnétiques (2a, 2b), les oscillateurs comprenant en outre des moyens transducteurs d'ondes magnétostatiques (5a, 5b, 6a, 6b) disposés sur les couches de façon que les directions de propagation de ces ondes dans les couches soient parallèles.

3. Magnétomètre selon la revendication 1, caractérisé par quatre oscillateurs (10a, 10b, 10c, 10d), dont les couches (2a, 2b, 2c, 2d) sont respectivement soumises deux à deux à des champs de même sens, (Ha, Hb), les moyens mélangeurs comprenant un premier et un deuxième mélangeur (111, 112) reliés respectivement à deux oscillateurs dont les couches sont soumises à des champs de sens opposés et un troisième mélangeur (110) ayant deux entrées respectivement reliées aux sorties des deux premiers mélangeurs (111, 112).

4. Magnétomètre selon la revendication 2, caractérisé en ce que les champs prédéterminés sont parallèles au plan de la couche et perpendiculaires à la direction de propagation des ondes dans les couches de façon à induire les ondes magnétostatiques de surface.

5. Magnétomètre selon la revendication 2, caractérisé en ce que les champs prédéterminés sont parallèles à la direction de propagation des ondes.

6. Magnétomètre selon la revendication 2, caractérisé en ce que les champs prédéterminés sont perpendiculaires au plan de la couche.

7. Magnétomètre selon la revendication 1, caractérisé en ce que le matériau magnétique (2a, 2b, 2c, 2d) est un grenat d'yttrium-fer déposé par épitaxie sur un substrat (1) de grenat de gadolinium-gallium.

8. Magnétomètre selon la revendication 1, caractérisé en ce que chaque couche comprend une cavité résonnante à réseaux (3a, 3b, 4a, 4b, 3c, 3d, 4c, 4d).

9. Magnétomètre selon la revendication 1, caractérisé en ce que chaque couche (2a, 2b) comprend une ligne à retard.

**Patentansprüche**

1. Mit magnetostatischen Wellen arbeitendes Magnetometer mit wenigstens zwei für magnetostatische Wellen empfindlichen Höchstfrequenzoszillatoren, dadurch gekennzeichnet, daß diese Oszillatoren eine monolithische Vorrichtung mit jeweils einer Schicht (2a, 2b) aus magnetischem Material, das dem zu messenden Feld (h) ausgesetzt ist, sowie elektromagnetische Vorrichtungen (8, 9) enthalten, die diese Schichten jeweils vorbe-stimmten Magnetfeldern ($H_a$, $H_b$) mit gleicher Richtung, die gleich der Richtung der maximalen Empfindlichkeit ist, und mit entgegengesetzten Vorzeichen sowie mit ähnlichen intensitäten aussetzen, wobei die Oszillatoren ähnliche Schwingungsfrequenzen aufweisen, daß Mischvorrichtungen (11) vorgesehen sind, die zwei an die Oszillatoren ($10_a$, $10_b$) angeschlossene Eingänge aufweisen und ein Signal liefern, dessen Frequenz gleich der Differenz der Schwingungsfrequenzen der zwei Oszillatoren ist und abhängig von der in dieser Richtung verlaufenden Komponente des zu messenden Feldes veränderlich ist.

2. Magnetometer nach Anspruch 1, dadurch gekennzeichnet, daß ein nichtmagnetisches Substrat (1) vorgesehen ist, auf dem die Schichten (2a, 2b) aus magnetischem Material aufgebracht sind, und daß die Oszillatoren Wandlervorrichtungen (5a, 5b, 6a, 6b) für magnetostatische Wellen enthalten, die auf den Schichten so angeordnet sind, daß die Ausbreitungsrichtungen dieser Wellen in den Schichten parallel zueinander verlaufen.

3. Magnetometer nach Anspruch 1, dadurch gekennzeichnet, daß vier Oszillatoren (10a, 10b, 10c, 10d) vorgesehen sind, deren Schichten (2a, 2b, 2c, 2d) jeweils paarweise Feldern ($H_a$, $H_b$) mit gleichem Vorzeichen ausgesetzt sind, daß die Mischervorrichtungen einen ersten und einen zweiten Mischer (111, 112) enthalten, die jeweils an zwei Oszillatoren angeschlossen sind, deren Schichten Feldern mit entgegengesetztem Vorzeichen ausgesetzt sind, sowie einen dritten Mischer (110) enthalten, der zwei Eingänge aufweist, die jeweils an Ausgänge der zwei zuvor genannten Mischer (111, 112) angeschlossen sind.

4. Magnetometer nach Anspruch 2, dadurch gekennzeichnet, daß die vorbestimmten Felder parallel zur Ebene der Schicht und senkrecht zur Ausbreitungsrichtung der Wellen in diesen Schichten verlaufen, so daß die magnetostatischen Oberflächenwellen erzeugt werden.

5. Magnetometer nach Anspruch 2, dadurch gekennzeichnet, daß die vorbestimmten Felder parallel zur Ausbreitungsrichtung der Wellen verlaufen.

6. Magnetometer nach Anspruch 2, dadurch gekennzeichnet, daß die vorbestimmten Felder senkrecht zur Ebene der Schicht verlaufen.

7. Magnetometer nach Anspruch 1, dadurch gekennzeichnet, daß das magnetische Material (2a, 2b, 2c, 2d) ein Yttrium-Eisen-Granat ist, der durch Epitaxie auf einem Substrat (1) aus Gadolinium-Gallium-Granat aufgebracht ist.

8. Magnetometer nach Anspruch 1, dadurch gekennzeichnet, daß jede Schicht einen Gitter-Resonanzraum (3a, 3b, 4a, 4b, 3c, 3d, 4c, 4d) enthält.

9. Magnetometer nach Anspruch 1, dadurch gekennzeichnet, daß jede Schicht (2a, 2b) eine Verzögerungsleitung enthält.

## Claims

1. Magnetometer operating with the aid of magnetostatic waves, comprising at least two ultra-high frequency oscillators, characterized in that each oscillator includes a monolithic device having a layer (2a, 2b) of magnetic material subjected to the field (h) to be measured and having electromagnetic means (8, 9) which apply to said layers predetermined magnetic fields ($H_a$, $H_b$) of the same direction equal to the direction of maximum sensitivity and having opposite signs and similar intensities, said oscillators having similar oscillating frequencies, and that mixing means (11) are provided which have two inputs connected to said oscillators (10a, 10b) and deliver a signal having a frequency which is equal to the difference of the oscillating frequencies of said two oscillators and which is variable in dependence on the component of said magnetic field to be measured which extends in said direction.

2. Magnetometer according to claim 1, characterized in that a non-magnetic substrate (1) is provided on which the layers (2a, 2b) of magnetic material are deposited, and that the oscillators include transducer means (5a, 5b, 6a, 6b) for magnetostatic waves, which are disposed on said layers in such a manner that the directions of propagation of said waves in said layers are parallel to each other.

3. Magnetometer according to claim 1, characterized in that four oscillators (10a, 10b, 10c, 10d) are provided the layers (2a, 2b, 2c, 2d) of which are two by two subjected to fields ($H_a$, $H_b$) of equal signs, that the mixing means include a first and a second mixer (112, 112) each of which being connected to two oscillators which have layers subjected to two fields of opposite signs, and further include a third mixer (110) having two inputs which are connected to the outputs of the two first-mentioned mixers (111, 112).

4. Magnetometer according to claim 2, characterized in that the predetermined fields extend parallel to the plane of the layer and perpendicular to the direction of propagation of the waves in these layers so that the magnetostatic surface waves are induced.

5. Magnetometer according to claim 2, characterized in that the predetermined fields extend parallel to the direction of propagation of said waves.

6. Magnetometer according to claim 2, characterized in that the predetermined fields extend perpendicular to the plane of the layer.

7. Magnetometer according to claim 1, characterized in that the magnetic material (2a, 2b, 2c, 2d) is yttrium iron garnet epitaxially deposited on a substrate (1) of gadolinium gallium garnet.

8. Magnetometer according to claim 1, characterized in that each layer includes a grid cavity resonator (3a, 3b, 4a, 4b, 3c, 3d, 4c, 4d).

9. Magnetometer according to claim 1, characterized in that each layer (2a, 2b) includes a delay line.

Fig. 1

**0015 168**

### FIG.2

### FIG.4

### FIG.5

2

FIG.3